# EUROPÄISCHE PATENTANMELDUNG

(11) **EP 0 635 884 A1**
(43) Veröffentlichungstag der Anmeldung: **25.01.1995**
(21) Anmeldenummer: 94109664.6
(22) Anmeldetag: 22.06.1994
(51) Int. Cl.: H01L 21/74, H01L 21/76

(54) **Verfahren zur Herstellung eines Grabens in einem Substrat und dessen Verwendung in der Smart-Power-Technologie**

(30) Priorität: 13.07.1993 DE 4323423
(71) Anmelder: SIEMENS AKTIENGESELLSCHAFT, D-80333 München (DE)
(72) Erfinder: Schwalke, Udo, Dr., D-84431 Heldenstein (DE)

(57) **Zusammenfassung**

Zur Herstellung eines Grabens (6) in einem Substrat, das mindestens eine erste Siliziumschicht (3), eine isolierende Schicht (2) und eine zweite Siliziumschicht (1) umfaßt, wird unter Verwendung einer Grabenmaske (4) eine erste Grabenätzung durch die erste Siliziumschicht (3) bis auf die isolierende Schicht (2) durchgeführt. Nach Verstärkung der Grabenmaske (4) durch eine nicht konform abgeschiedene Schutzschicht (7) wird in einer zweiten Grabenätzung die isolierende Schicht (2) bis auf die zweite Siliziumschicht (1) durchgeätzt. Das Verfahren ist insbesondere geeignet zur Herstellung von Isolationsgräben mit integrierter Substratkontaktierung für Smart-Power-Technologie auf einem SOI-Substrat.

## Beschreibung

Für verschiedene Anwendungen ist es erforderlich, Gräben mit hohem Aspektverhältnis (Aspektverhältnis ist der Quotient aus Grabentiefe zu Grabenweite) in Substraten herzustellen, die mindestens an der Oberfläche eine erste Siliziumschicht, darunter eine isolierende Schicht und darunter eine zweite Siliziumschicht aufweisen. Die Gräben sollen dabei durch die erste Siliziumschicht und die isolierende Schicht bis auf die zweite Siliziumschicht reichen.

Derartige Gräben werden zum Beispiel benötigt zur Kontaktierung von Schaltelementen in dreidimensionalen Schaltungen, die in übereinander angeordneten, jeweils durch isolierende Schichten getrennten Siliziumschichten realisiert sind.

Eine weitere Anwendung für derartige Gräben tritt in der Smart-Power-Technologie auf SOI-Substraten auf. In der Smart-Power-Technologie werden komplexe Logikbauelemente mit Hochspannungs-Leistungsbauelementen monolithisch in einem Substrat integriert. Da die Logikbauelemente mit Spannungspegeln um 5 Volt betrieben werden, bei den Hochspannungs-Leistungsbauelementen jedoch Spannungen bis zu 500 Volt auftreten, ist eine elektrische Trennung der Hochspannungsbauelemente von den Logikbauelementen erforderlich.

Es ist bekannt (siehe zum Beispiel Yu Ohata et al, IEEE CICC, S. 443 bis 446; A. Nakagawa et al. ISPS 1990, S. 97 bis 101), die Hoch- und Niederspannungsbauelemente durch dielektrische Isolation elektrisch vollständig gegeneinander zu isolieren. Dazu werden die Bauelemente in einem SOI-Substrat realisiert. Ein SOI-Substrat umfaßt auf einer einkristallinen Siliziumscheibe eine isolierende Schicht aus SiO₂ und auf der isolierenden Schicht eine einkristalline Siliziumschicht, die die Oberfläche des SOI-Substrats umfaßt. Die Bauelemente werden in der einkristallinen Siliziumschicht realisiert. Die isolierende Schicht des SOI-Substrats stellt die vertikale Isolation sicher, während die laterale Isolation der Bauelemente durch mit isolierendem Material gefüllte Gräben realisiert wird. Diese Gräben reichen bis auf die Oberfläche der isolierenden Schicht. Sie umgeben das zu isolierende Bauelement in der einkristallinen Siliziumschicht vollständig. Zur Füllung der Gräben wird zum Beispiel die Seitenwand thermisch aufoxidiert, der verbleibende Zwischenraum mit Polysilizium aufgefüllt, rückgeätzt und anschließend an der Oberfläche aufoxidiert. Die Grabenfüllung besteht dann aus einem Polysiliziumkern, der vollständig von Siliziumoxid eingeschlossen ist.

Der Graben wird unter Verwendung einer Grabenmaske, die überwiegend aus SiO₂ besteht, erzeugt. Soll der Graben durch die isolierende Schicht durch bis auf die Oberfläche der einkristallinen Siliziumscheibe, die in diesem Fall die zweite Siliziumschicht darstellt, geätzt werden, um zum Beispiel einen Kontakt zu der einkristallinen Siliziumscheibe herzustellen, wird bei dieser Ätzung auch die Grabenmaske angegriffen. Ist die Dicke der Grabenmaske vergleichbar mit oder geringer als die der isolierenden Schicht, so wird bei der Ätzung die Oberfläche der Siliziumschicht, in der die aktiven Bauelemente integriert werden, angeätzt und geschädigt.

Der Erfindung liegt das Problem zugrunde, ein Verfahren zur Herstellung eines Grabens in einem Substrat anzugeben, mit dem ein durch eine erste Siliziumschicht und eine isolierende Schicht hindurchreichender Graben ohne Beschädigung der Oberfläche der ersten Siliziumschicht herstellbar ist. Das Verfahren soll insbesondere zur Herstellung eines Isolationsgrabens für Smart-Power-Technologien auf einem SOI-Substrat geeignet sein.

Dieses Problem wird erfindungsgemäß gelöst durch ein Verfahren nach Anspruch 1. Weitere Ausgestaltungen der Erfindung gehen aus den übrigen Ansprüchen hervor.

Erfindungsgemäß erfolgt die Bildung des Grabens in zwei Grabenätzungen. In einer ersten Grabenätzung wird die erste Siliziumschicht bis auf die Oberfläche der isolierenden Schicht durchätzt. Dann wird die Grabenmaske durch eine nicht konform abgeschiedene Schutzschicht verstärkt. Bei der nicht konformen Abscheidung ist die Dicke der Schutzschicht auf waagerechten Flächen der Grabenmaske größer als an Seitenwänden und dem Boden des Grabens. In einer zweiten Grabenätzung wird anschließend die isolierende Schicht durchätzt, so daß der Graben bis auf die Oberfläche der zweiten Siliziumschicht reicht. Die Dicke der Schutzschicht auf den waagerechten Flächen der Grabenmaske wird dabei mindestens so groß eingestellt, daß bei der zweiten Grabenätzung ein Durchätzen der isolierenden Schicht und ein Entfernen der Schutzschicht und der Grabenmaske auf waagerechten Flächen im wesentlichen gleichzeitig erreicht wird. Diese Maßnahme stellt sicher, daß die erste Siliziumschicht beim Durchätzen der isolierenden Schicht nicht angegriffen wird. Da die Schutzschicht nicht konform abgeschieden worden ist, ist auf diese Weise ein gleichzeitiger Schutz der Oberfläche der ersten Siliziiumschicht und ein Durchätzen der isolierenden Schicht möglich.

Es ist besonders vorteilhaft, die Schutzschicht durch nicht konforme Abscheidung von CVD-SiO₂ herzustellen. In der Halbleitertechnologie sind eine Vielzahl von nicht konformen Abscheideprozessen bekannt, bei denen die Nichtkonformität der Abscheidung in der Regel als Nachteil empfunden wird. In dem erfindungsgemäßen Verfahren wird die nicht-konforme Abscheidung gezielt eingesetzt. Dabei ist es von Vorteil, solche Abscheideverfahren zu wählen, bei denen der Dickenunterschied auf der waagerechten Oberfläche und an senkrechten Flanken besonders groß ist, weil dann im Graben nur eine dünne zusätzliche Schicht entsteht, die bei der zweiten Grabenätzung entfernt werden muß.

Es liegt insbesondere im Rahmen der Erfindung, die Schutzschicht in einem Plasma unterstützten CVD-Verfahren durch Zersetzung von Si(OC₂H₅)₄ (TEOS) oder durch Abscheidung bei Atmosphärendruck von Borsilikatglas, Phosphorsilikatglas oder Borphosphorsilikatglas gebildet wird.

Wird die Schutzschicht aus Borsilikatglas oder Phosphorsilikatglas gebildet, so liegt es im Rahmen der Erfindung, nach dem Abscheiden der Schutzschicht und vor der zweiten Grabenätzung einen Temperschritt durchzuführen. In diesem Temperschritt werden durch Ausdiffusion aus der Schutzschicht in der ersten Siliziumschicht dem Graben benachbarte Diffusionsgebiete erzeugt. In der Smart-Power-Technologie werden derartige, einem Isolationsgraben benachbarte Diffusionsgebiete zur Verbesserung des Spannungsverhaltens der Schaltung eingesetzt. Diese Diffusionsgebiete sind in dem erfindungsgemäßen Verfahren ohne zusätzliche Schichtabscheidung herstellbar.

Es liegt im Rahmen der Erfindung, die Seitenwände des Grabens mit einer Isolationsstruktur zu versehen und den Graben mit einer Siliziumfüllung aus zum Beispiel in situ dotiertem Silizium aufzufüllen. Die Siliziumfüllung reicht dabei bis auf die Oberfläche der zweiten Siliziumschicht. Über die dotierte Siliziumfüllung kann ein Kontakt zu der zweiten Siliziumschicht gebildet werden, um so zum Beispiel eine elektrische Abschirmung der Bauelemente gegeneinander zu realisieren.

Werden die zweite Siliziumschicht und die Siliziumfüllung vom entgegengesetzten Leitfähigkeitstyp dotiert, so wird auf diese Weise eine Diode hergestellt.

Die Isolationsstruktur an den Seitenwänden des Grabens wird insbesondere durch ganzflächige Abscheidung einer im wesentlichen konformen Siliziumschicht und anisotropes Rückätzen der konformen Siliziumschicht selektiv zur Unterlage und anschließende thermische Oxidation hergestellt. Dabei entsteht die Isolationsstruktur in Form von oxidierten Siliziumspacern. Um die Selektivität für die anisotrope Ätzung zu erzielen, liegt es im Rahmen der Erfindung, unter der konformen Siliziumschicht eine Schicht aus zum Beispiel Si₃N₄ abzuscheiden. Der freiliegende Teil der Si₃N₄-Schicht muß dann am Boden des Grabens entfernt werden.

Das Verfahren ist insbesondere zur Herstellung eines Grabens in einem SOI-Substrat geeignet, wobei die erste Siliziumschicht die monokristalline Siliziumschicht, die isolierende Schicht, die vergrabene SiO₂-Schicht und die zweite Siliziumschicht die monokristalline Siliziumscheibe des SOI-Substrats bilden.

Das Verfahren ist auch einsetzbar zur Herstellung von Gräben in einem Substrat, das mindestens zwei Siliziumschichten, die jeweils durch eine darunterliegende isolierende Schicht von der nächsten Siliziumschicht isoliert ist, aufweist.

Im weiteren wird die Erfindung anhand eines Ausführungsbeispiels und der Figuren näher erläutert.
- Figur 1: zeigt ein SOI-Substrat mit Grabenmaske.
- Figur 2: zeigt das SOI-Substrat nach der ersten Grabenätzung.
- Figur 3: zeigt das SOI-Substrat nach Abscheidung einer Schutzschicht.
- Figur 4: zeigt das SOI-Substrat nach Entfernen der Anteile der Schutzschicht, die an den Seitenwänden und am Boden des Grabens angeordnet sind.
- Figur 5: zeigt das SOI-Substrat nach der zweiten Grabenätzung.
- Figur 6: zeigt das SOI-Substrat nach Abscheidung einer Si₃N₄-Schicht und einer konformen Siliziumschicht.
- Figur 7: zeigt das SOI-Substrat nach Herstellung von Siliziumspacern.
- Figur 8: zeigt das SOI-Substrat nach Herstellung einer Isolationsstruktur durch Aufoxidation der Siliziumspacer.
- Figur 9: zeigt das SOI-Substrat nach Entfernen der freiliegenden, am Boden des Grabens angeordneten Teile der Si₃N₄-Schicht.
- Figur 10: zeigt das SOI-Substrat nach Abscheidung einer Siliziumschicht, die den Graben auffüllt.
- Figur 11: zeigt das SOI-Substrat nach Rückätzen der Siliziumschicht.
- Figur 12: zeigt das SOI-Substrat nach Oxidation der Oberfläche der Siliziumfüllung im Graben.
- Figur 13: zeigt das SOI-Substrat nach Abscheiden einer Passivierungsschicht und Herstellung eines mit einer Metallisierung gefüllten Kontaktloches zu der Siliziumfüllung im Graben.

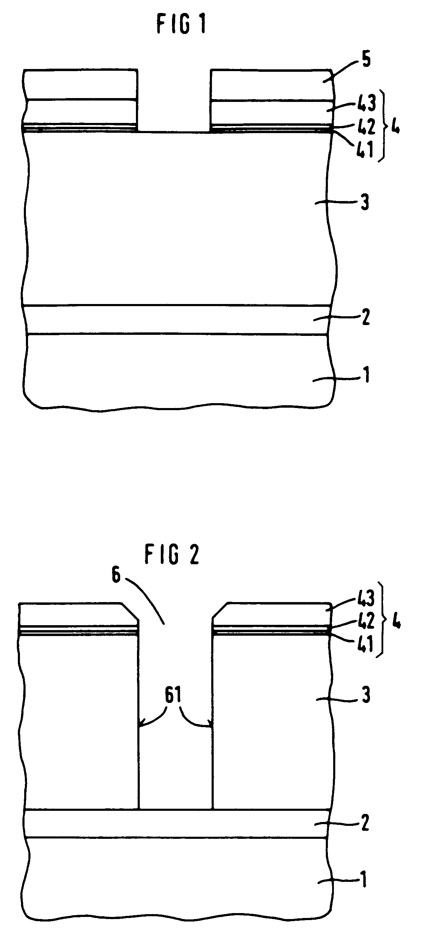

Ein SOI-Substrat umfaßt eine monokristalline Siliziumscheibe 1, die zum Beispiel p⁺-dotiert ist, eine darauf angeordnete isolierende Schicht 2 aus SiO₂ und eine darauf angeordnete monokristalline Siliziumschicht 3 (siehe Figur 1). Dabei entspricht die monokristalline Siliziumscheibe 1 der zweiten Siliziumschicht gemäß Anspruch 1 und die monokristalline Siliziumschicht 3 der ersten Siliziumschicht gemäß Anspruch 1.

Das SOI-Substrat ist vorzugsweise nach dem direct wafer bonding (DWB) oder silicon direct bonding (SDB)-Verfahren, das zum Beispiel aus Yu Ohata et al, IEEE 1987 CICC, S. 443 bis 446, bekannt ist, hergestellt. Die Dicke der isolierenden Schicht 2 beträgt zum Beispiel 2 µm. Die Dicke der monokristallinen Siliziumschicht 3 beträgt zum Beispiel 20 µm. Die monokristalline Siliziumschicht 3 ist schwach n-dotiert. Die Dotierstoffkonzentration in der monokristallinen Siliziumschicht 3 beträgt zum Beispiel 10¹⁴ Phosphoratome/cm³. In der monokristallinen Siliziumschicht 3 werden später Bauelemente einer Smart-Power-Schaltung hergestellt.

Auf die Oberfläche der monokristallinen Siliziumschicht 3 wird eine Grabenmaske 4 aufgebracht. Die Grabenmaske 4 umfaßt eine untere Schicht 41, eine mittlere Schicht 42 und eine obere Schicht 43. Die untere Schicht 41 wird zum Beispiel durch thermische Oxidation in einer Dicke von 50 nm hergestellt. Die mittlere Schicht 42 wird zum Beispiel durch CVD-Abscheidung von Si₃N₄ in einer Dicke von 150 nm hergestellt. Die obere Schicht 43 wird zum Beispiel durch CVD-Abscheidung von SiO₂ in einer Dicke von 1600 nm hergestellt. Zur Strukturierung der Grabenmaske 4 wird auf diese Schichtenfolge eine Lackmaske 5 aufgebracht. Die Grabenmaske 4 wird mit Hilfe der Lackmaske 5 in einem CHF₃/O₂-Trockenätzprozeß strukturiert. Die Grabenmaske 4 muß zum Ätzen eines tiefen Grabens geeignet sein.

Nach Entfernen der Lackmaske 5 durch Lackstrippen wird in einer ersten Grabenätzung mit Hilfe der Grabenmaske 4 ein Graben 6 in die monokristalline Siliziumschicht 3 geätzt (siehe Figur 2). Die Ätzung erfolgt anisotrop in einem Trockenätzprozeß mit einer Cl₂/O₂-Chemie. Die Ätzung erfolgt selektiv zu SiO₂. Daher stoppt die Ätzung, sobald die Oberfläche der isolierenden Schicht 2 freigelegt ist.

Zur Bildung von sauberen Seitenwänden 61 des Grabens 6 werden an den Seitenwänden befindliche Ätzprodukte in einem HF-Dip entfernt.

Die Weite des Grabens 6 beträgt zum Beispiel 3 µm. Der Graben 6 umgibt einen Bereich der monokristallinen Siliziumschicht 3 vollständig, in dem später ein zu isolierendes Bauelement hergestellt wird.

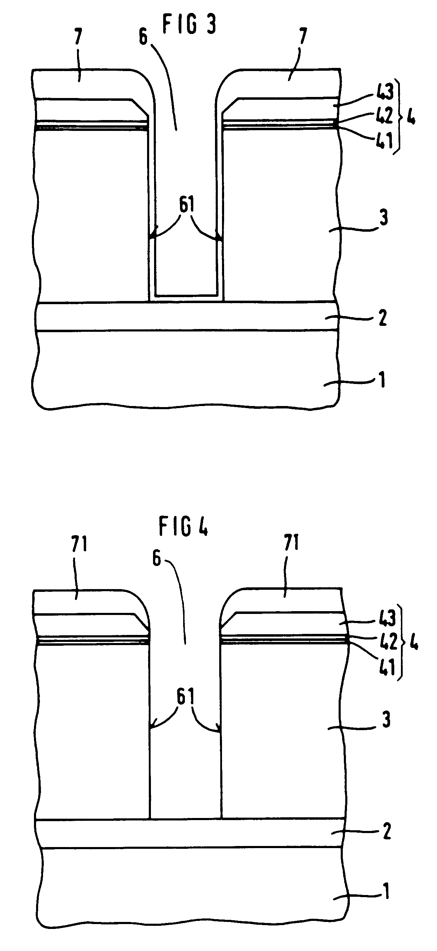

Es wird ganzflächig eine Schutzschicht 7 durch nicht-konforme CVD-Abscheidung von SiO₂ aufgebracht. Die Schutzschicht 7 weist an der Oberfläche der Grabenmaske 4 eine Dicke von zum Beispiel 2 µm auf. Bedingt durch die nicht-konforme Abscheidung ist die Dicke der Schutzschicht 7 an der Oberfläche der Seitenwände 61 sowie an der Oberfläche der isolierenden Schicht 2 sehr viel geringer. Bei plasmaunterstützter CVD-Abscheidung in einem TEOS-Verfahren ist die Schichtdicke an der Oberfläche der Seitenwände 61 etwa 400 nm (siehe Figur 3).

Sollen dem Graben 6 benachbarte Diffusionsgebiete (nicht dargestellt) in den Seitenwänden 61 hergestellt werden, so wird die Schutzschicht 7 aus dotiertem Glas, je nach Dotierstofftyp Borsilikatglas oder Phosphorsilikatglas, durch APCVD-Abscheidung gebildet. Nach der Abscheidung der Schutzschicht 7 wird der Dotierstoff dann durch eine Temperung bei zum Beispiel 1000°C in die Seitenwände 61 eingetrieben, wobei ein Diffusionsgebiet gebildet wird.

In einer isotropen naßchemischen Ätzung, zum Beispiel in einem HF-Dip, werden die an der Oberfläche der Seitenwände 61 und der isolierenden Schicht 2 angeordneten Anteile der Schutzschicht 7 entfernt. Auf der Oberfläche der Grabenmaske verbleibt dabei ein Schutzschichtrest 71, da hier die Schutzschicht 7 erheblich dicker war. Der Schutzschichtrest 71 und die obere Schicht 43 der Grabenmaske 4 weisen eine Gesamtdicke von etwa 3 µm auf (siehe Figur 4).

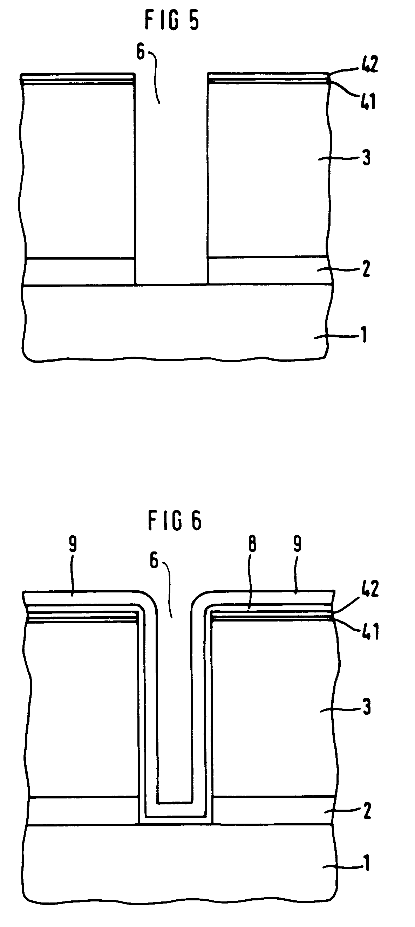

Nachfolgend wird eine zweite Grabenätzung durchgeführt. Dazu wird mittels anisotroper Trockenätzung die isolierende Schicht 2 bis auf die Oberfläche der monokristallinen Siliziumscheibe 1 geätzt (siehe Figur 5). Diese anisotrope Trockenätzung erfolgt selektiv zu Silizium und stoppt daher auf der Oberfläche der monokristallinen Siliziumscheibe 1. Als Trockenätzung ist zum Beispiel ein CHF₃/O₂-Prozeß geeignet. Bei der Trockenätzung wird gleichzeitig der Schutzschichtrest 71 und die obere Schicht 43 der Grabenmaske 4 entfernt. Die Dicke von Schutzschichtrest 71 und oberer Schicht 43 der Grabenmaske 4 muß so groß sein, daß ein Angriff der Oberfläche der monokristallinen Siliziumschicht 3 bei der zweiten Grabenätzung vermieden wird. Daher wird die Schutzschicht 7 mindestens in einer solchen Dicke auf waagerechte Flächen der Grabenmaske 4 abgeschieden, daß ein Durchätzen der Schutzschicht 7 und der isolierenden Schicht 2 bei der zweiten Grabenätzung im wesentlichen zum gleichen Zeitpunkt erfolgt.

Es wird ganzflächig durch CVD-Abscheidung eine Si₃N₄-Schicht 8 in einer Dicke von zum Beispiel 40 nm abgeschieden. Auf die Si₃N₄-Schicht 8 wird eine amorphe Siliziumschicht 9 in einer Dicke von zum Beispiel 400 nm abgeschieden. Die amorphe Siliziumschicht 9 weist eine im wesentlichen konforme Kantenbedeckung auf (siehe Figur 6).

Die amorphe Siliziumschicht 9 ist undotiert. Anstelle der amorphen Siliziumschicht 9 kann auch eine Polysiliziumschicht verwendet werden, amorphes Silizium wird jedoch wegen der feineren Struktur dem Polysilizium vorgezogen. Die Schichtdicke der amorphen Siliziumschicht 9 wird abhängig von der Grabenweite auf die vorgegebene Grabengeometrie optimiert.

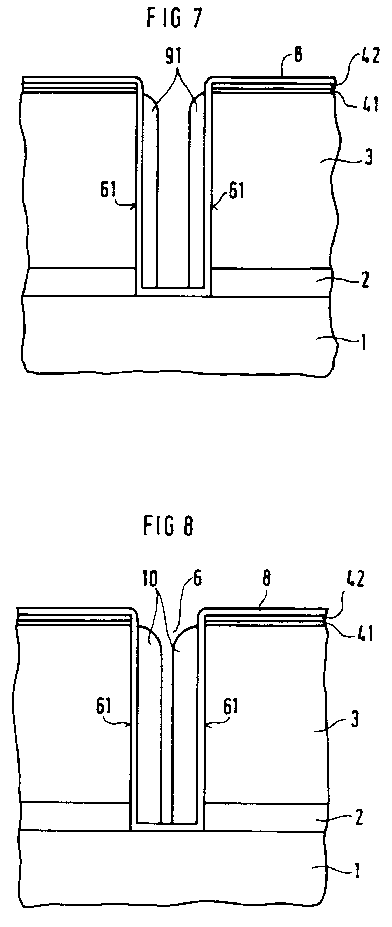

Nachfolgend wird eine zu Si₃N₄ selektive, anisotrope Ätzung durchgeführt, bei der waagerechte Flächen der Si₃N₄-Schicht 8 freigelegt werden und bei der aus der amorphen Siliziumschicht 9 Siliziumspacer 91 gebildet werden (siehe Figur 7).

Durch thermische Oxidation der Siliziumspacer 91 zum Beispiel bei 1000°C in feuchter Atmosphäre wird eine Isolationsstruktur 10 erzeugt. Die Isolationsstruktur 10 bedeckt die Si₃N₄-Schicht 8 im Bereich der Seitenwände 61. Am Boden des Grabens 6 liegt die Oberfläche der Si₃N₄-Schicht frei.

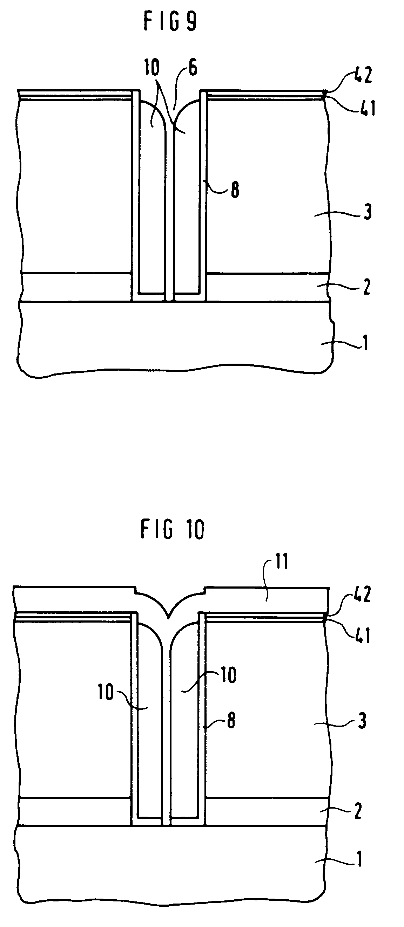

In einer zu SiO₂ und Si selektiven Ätzung, zum Beispiel mit H₃PO₄, wird die Si₃N₄-Schicht 8 am Boden des Grabens 6 entfernt. Dabei wird die Oberfläche der monokristallinen Siliziumscheibe 1 freigelegt (siehe Figur 9). Bei dieser Ätzung kann die mittlere Schicht 42 der Grabenmaske 4 verdünnt werden.

Im Graben zwischen der Isolationsstruktur 10 verbliebener Freiraum wird anschließend durch Abscheidung einer weiteren Siliziumschicht 11 mit in situ dotiertem amorphem Silizium aufgefüllt (siehe Figur 10).

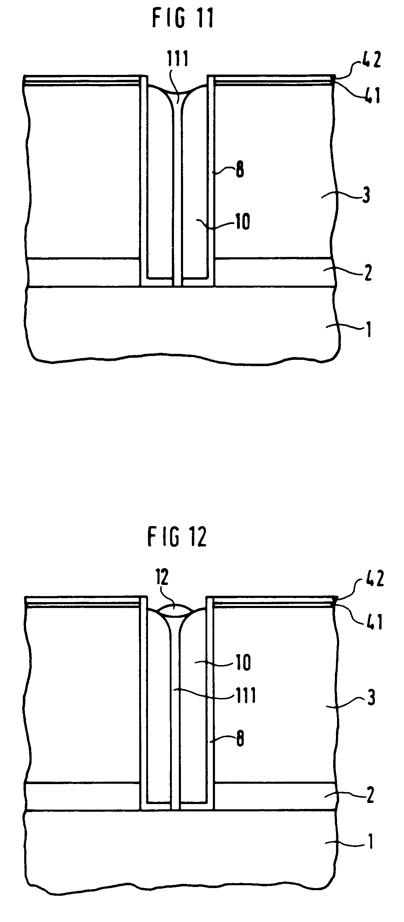

Die weitere Siliziumschicht 11 wird anschließend selektiv zu Si₃N₄ und SiO₂ geätzt, wobei aus der weiteren Siliziumschicht 11 eine Siliziumfüllung 111 entsteht (siehe Figur 11). Die Ätzung wird so ausgelegt, daß die Oberkante der Siliziumfüllung 111 unterhalb der unteren Schicht 41 der Grabenmaske 4 abschließt. Die Dotierung der weiteren Siliziumschicht 11 und damit der Siliziumfüllung 111 wird abhängig von dem vorgegebenen Zweck des Grabens eingestellt: Soll über den Graben die monokristalline Siliziumscheibe 1 kontaktiert werden, so wird die Siliziumfüllung 111 vom selben Leitfähigkeitstyp wie die monokristalline Siliziumscheibe 1 dotiert. Sollen dagegen die Siliziumfüllung 111 und die monokristalline Siliziumscheibe 1 als Diode betrieben werden, so werden beide Bestandteile vom entgegengesetzten Leitfähigkeitstyp dotiert.

Durch thermische Oxidation der Oberfläche der Siliziumfüllung 111 zum Beispiel in feuchter Atmosphäre bei 1000°C wird selbstjustiert ein Isolationsabschluß 12 gebildet (siehe Figur 12). Der Isolationsabschluß 12 überdeckt die Siliziumfüllung 111 vollständig. In den Temperschritt zur thermischen Oxidation wird der Dotierstoff in der Siliziumfüllung 111 aktiviert. Die ser diffundiert in die monokristalline Siliziumscheibe 1 und bildet an der Grenzfläche zur monokristallinen Siliziumscheibe 1 einen Kontakt bzw. einen pn-Übergang.

Anschließend kann die Grabenmaske entfernt werden.

In der monokristallinen Siliziumschicht 3 werden anschließend aktive Bauelemente hergestellt. Zu isolierende aktive Bauelemente werden dabei ringförmig von einem Graben, der entsprechend der Erfindung hergestellt und gefüllt ist, umgeben. Die Herstellung der Bauelemente und die Bauelemente selbst sind nicht im einzelnen dargestellt.

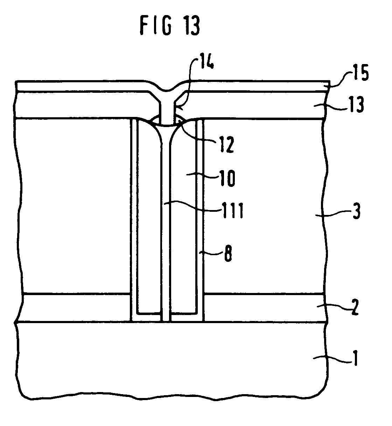

Nach Fertigstellung der Bauelemente wird ein Zwischenoxid 13 zum Beispiel durch CVD-Abscheidung von TEOS und Borphosphorsilikatglas abgeschieden. Bei 900°C in N₂-Atmosphäre während 40 Minuten wird das Zwischenoxid 13 planarisiert. In dem Zwischenoxid 13 und im Isolationsabschluß 12 wird ein Kontaktloch 14 durch Ätzen geöffnet. Das Kontaktloch 14 reicht auf die Oberfläche der Siliziumfüllung 111. Durch Abscheidung einer Metallschicht 15 wird das Kontaktloch 14 mit einer Metallisierung zur Kontaktierung der Siliziumfüllung 111 aufgefüllt (siehe Figur 13).

Das Ausführungsbeispiel ist analog übertragbar auf die Herstellung eines Grabens in einem Substrat, das mehrere gegeneinander isolierte Siliziumschichten aufweist.

## Patentansprüche

1. Verfahren zur Herstellung eines Grabens in einem Substrat,
- bei dem das Substrat, das mindestens eine an der Oberfläche angeordnete erste Siliziumschicht (3), eine darunter angeordnete isolierende Schicht (2) und eine darunter angeordnete zweite Siliziumschicht (1) umfaßt, mit einer Grabenmaske (4) versehen wird,
- bei dem zur Bildung des Grabens (6) eine erste Grabenätzung bis auf die Oberfläche der isolierenden Schicht (2) erfolgt,
- bei dem ganzflächig eine Schutzschicht (7) nicht konform abgeschieden wird, deren Dicke auf waagerechten Flächen der Grabenmaske (4) größer ist als an Seitenwänden (61) und dem Boden des Grabens (6),
- bei dem zum Erreichen der vorgegebenen Tiefe des Grabens (6) eine zweite Grabenätzung bis auf die Oberfläche der zweiten Siliziumschicht (1) durchgeführt wird,
- bei dem die Dicke der Schutzschicht (7) auf waagerechten Flächen der Grabenmaske (4) mindestens so groß eingestellt wird, daß bei der zweiten Grabenätzung ein Durchätzen der isolierenden Schicht (2) und ein Entfernen der Schutzschicht und der Grabenmaske (4) auf waagerechten Flächen im wesentlichen gleichzeitig erreicht wird.

2. Verfahren nach Anspruch 1,
bei dem die Schutzschicht (7) in einem plasmaunterstützen CVD-Verfahren durch Zersetzung von Si(OC₂H₅)₄ (TEOS) oder durch CVD-Abscheidung bei Atmosphärendruck (APCVD) von Borsilikatglase (BSG), Phosphorsilikatglas (PSG), Borphosphorsilikatglas (BPSG), undotiertes Silikatglas (NSG) oder Oxid gebildet wird.

3. Verfahren nach Anspruch 2,
- bei dem die Grabenmaske (4) mindestens an den waagerechten Flächen SiO₂ umfaßt,
- bei dem die isolierende Schicht (2) aus SiO₂ besteht,
- bei dem die erste Grabenätzung selektiv zu SiO₂ erfolgt,
- bei dem die zweite Grabenätzung selektiv zu Si erfolgt.

4. Verfahren nach einem der Ansprüche 2 oder 3,
- bei dem die Schutzschicht (7) aus Borsilikatglas oder Phosphorsilikatglas gebildet wird,
- bei dem nach dem Abscheiden der Schutzschicht (7) und vor der zweiten Grabenätzung ein Temperschritt durchgeführt wird, in dem durch Ausdiffusion aus der Schutzschicht (7) in der ersten Siliziumschicht (3) dem Graben (6) benachbarte Diffusionsgebiete erzeugt werden.

5. Verfahren nach einem der Ansprüche 1 bis 4,
- bei dem die Seitenwände (61) des Grabens (6) mit einer Isolationsstruktur (10) versehen werden,
- bei dem der Graben (6) mit einer Siliziumfüllung (111) aus dotiertem Silizium aufgefüllt wird.

6. Verfahren nach Anspruch 5,
bei dem der Graben (6) mit der Siliziumfüllung (111) aus in situ dotiertem amorphen Silizium gefüllt wird.

7. Verfahren nach Anspruch 5 oder 6,
bei dem die zweite Siliziumschicht (1) und die Siliziumfüllung (111) von entgegengesetztem Leitfähigkeitstyp dotiert werden, so daß eine Diode entsteht.

8. Verfahren nach einem der Ansprüche 5 bis 7 in Verbindung mit Anspruch 3,
- bei dem die Grabenmaske (4) aus einer unteren Schicht (41) aus SiO₂, einer mittleren Schicht (42) aus Si₃N₄ und einer oberen Schicht (43) aus SiO₂ gebildet wird,
- bei dem nach der zweiten Grabenätzung die restlichen Teile (71) der Schutzschicht (7) und die obere Schicht (43) der Grabenmaske (4) in einem zu Silizium und Si₃N₄ selektiven Ätzschritt entfernt werden,
- bei dem ganzflächig eine Si₃N₄-Schicht (8) mit im wesentlichen konformer Kantenbedeckung abgeschieden wird,
- bei dem ganzflächig eine im wesentlichen konforme Siliziumschicht (9) abgeschieden wird,
- bei dem die konforme Siliziumschicht (9) in einem anisotropen Ätzprozeß selektiv zu Si₃N₄ geätzt wird, so daß waagerechte Flächen der Si₃N₄-Schicht (8) freigelegt werden und an senkrechten Flanken des Grabens (6) Siliziumspacer (91) entstehen,
- bei dem durch eine thermische Oxidation der Siliziumspacer (91) die Isolationsstruktur (10) entsteht,
- bei dem in einem zu SiO₂ und Silizium selektiven Ätzschritt der am Boden des Grabens (6) freiliegende Teil der Si₃N₄-Schicht (8) entfernt wird.

9. Verfahren nach Anspruch 8,
- bei dem die Siliziumfüllung (111) durch ganzflächiges Abscheiden einer in situ dotierten weiteren im wesentlichen konformen Siliziumschicht (11) und anisotropes Ätzen der weiteren im wesentlichen konformen Siliziumschicht (11) gebildet wird, wobei das anisotrope Ätzen so ausgelegt wird, daß die Oberfläche der mittleren Schicht der Grabenmaske freigelegt wird und die Siliziumfüllung unterhalb der unteren Schicht (41) der Grabenmaske (4) abschließt,
- bei dem durch eine thermische Oxidation der freiliegenden Oberfläche der Siliziumfüllung (111) ein Isolationsabschluß (12) erzeugt wird, der die Siliziumfüllung (111) vollständig überdeckt,
- bei dem nach Entfernen der mittleren Schicht (42) der Grabenmaske (4) und der freiliegenden Anteile der Si₃N₄-Schicht (8) in der ersten Siliziumschicht (3) mikroelektronische Bauelemente hergestellt werden,
- bei dem nach ganzflächigem Abscheiden einer Zwischenoxidschicht (13) mindestens ein Kontaktloch (14) geöffnet wird, das durch die Zwischenoxidschicht (13) und den Isolationsabschluß (12) auf die Siliziumfüllung (111) reicht und das mit einer Metallisierung (15) aufgefüllt wird.

10. Verfahren nach einem der Ansprüche 1 bis 9,
bei dem die erste Siliziumschicht (3) eine monokristalline Siliziumschicht, die isolierende Schicht (2) eine SiO₂-Schicht und die zweite Siliziumschicht (1) eine monokristalline Siliziumscheibe ist, die zusammen ein SOI-Substrat bilden.

11. Verfahren zur Herstellung einer integrierten Schaltung, die sowohl komplexe Logikbauelemente als auch Hochspannungs-Leistungsbauelemente umfaßt, unter Verwendung des Verfahrens nach Anspruch 10,
bei dem der Graben als Isolationsgraben und Substratkontakt hergestellt wird.

12. Verfahren nach Anspruch 11,
bei dem die erste Siliziumschicht (3) eine Dicke von 10 bis 30 µm und der Graben eine Weite von 2 bis 5 µm aufweist.
